# EUROPÄISCHE PATENTSCHRIFT

(11) **EP 1 855 993 B1**
(45) Veröffentlichungstag und Bekanntmachung des Hinweises auf die Patenterteilung: **24.11.2010**
(21) Anmeldenummer: 06723190.2
(22) Anmeldetag: 03.03.2006
(51) Int. Cl.: C01B 33/02, C01B 33/027, B01J 19/24, B01J 15/00

(54) **REAKTOR UND VERFAHREN ZUR HERSTELLUNG VON SILIZIUM**
REACTOR AND METHOD FOR PRODUCING SILICON
REACTEUR ET PROCEDE DE PRODUCTION DE SILICIUM

(30) Priorität: 05.03.2005 DE 102005010218
(43) Veröffentlichungstag der Anmeldung: 21.11.2007
(73) Patentinhaber: JSSi GmbH, 09599 Freiberg (DE)
(72) Erfinder: BERTHOLD, Rico, 01187 Dresden (DE); BEYER, Christian, 09599 Freiberg (DE); MÜLLER, Armin, 09599 Freiberg (DE); PÄTZOLD, Carsten, 02994 Wiednitz (DE); SILL, Torsten, 09599 Freiberg (DE); SINGLIAR, Ute, 09603 Grossschirma/OT Obergruna (DE); SONNENSCHEIN, Raymund, 60594 Frankfurt (DE); ZIEGENBALG, Gerald, 09599 Freiberg (DE)
(74) Vertreter: Rau, Albrecht
(86) Internationale Anmeldenummer: PCT/EP2006/001945
(87) Internationale Veröffentlichungsnummer: WO 2006/094714

(56) Entgegenhaltungen:
- US-A- 4 314 525
- US-A- 4 354 987
- US-A- 4 661 335
- US-A1- 2003 175 196

## Beschreibung

Die Erfindung betrifft einen Reaktor zur Zersetzung eines Silizium enthaltenden Gases, insbesondere zur Zersetzung von Monosilan oder Trichlorsilan. Die Erfindung betrifft ferner ein Verfahren zur Herstellung von Silizium, das als Ausgangsstoff für die Fertigung von polykristallinen Siliziumblöcken oder Silziumeinkristallen für die Photovoltaik geeignet ist.

Verfahren zur Herstellung von hochreinem Silizium sind seit Langem bekannt. In DE 10 2004 027 563.7 ist beispielsweise ein energie- und kostensparendes Herstellungsverfahren für hochreines Silizium bekannt, bei dem ein Monosilan-Wasserstoff-Gasgemisch thermisch zersetzt wird, und pulverförmiges Silizium in der Gasphase entsteht, das anschließend mechanisch verdichtet wird. Bei diesem Herstellungsverfahren ist es möglich, dass sich das aus der Gasphase abgeschiedene Silizium auf der beheizten Innen-Wand des Reaktor-Behälters als Schicht ablagert. Der Reaktor-Behälter besteht in der Regel aus Quarzglas, das einen im Vergleich zu Silizium unterschiedlichen Wärmeausdehnungskoeffizienten aufweist. Während des Reaktorbetriebs kommt es an der Innen-Wand des Reaktor-Behälters in zunehmendem Maße zu einer Ablagerung von Silizium. Dies führt einerseits dazu, dass sich die Wärmeleitung von der außerhalb der Reaktions-Kammer angeordneten Heiz-Vorrichtung zu der Reaktions-Kammer reduziert und andererseits dazu, dass nach Ablauf einer gewissen Zeitdauer der Reaktor-Behälter mechanisch oder chemisch von der abgelagerten Siliziumschicht gereinigt werden muss. Dies führt möglicherweise zu Unterbrechungen des Reaktorbetriebs. Weiterhin kommt es infolge der unterschiedlichen Wärmeausdehnungskoeffizienten des Reaktor-Behälters und der Siliziumschicht bei einer Abkühlung des Reaktor-Behälters zu großen Kräften und Spannungen zwischen der abgelagerten Siliziumschicht und dem Quarzglas. Dies kann zu Beschädigungen des Reaktor-Behälters führen, insbesondere zu Rissen und Abplatzungen, die in das abgeschiedene pulverförmige Silizium gelangen und dieses verunreinigen.

Aus der EP 1 550 636 A1 ist ein Reaktor und ein Verfahren zur Herstellung von hochreinem Silizium mittels einer Reaktion von Siliziumtetrachlorid und Zink bekannt.

Aus der US 4 314 525 ist ein Reaktor zur thermischen Zersetzung von Silangas bekannt.

Aus der US 4 354 987 ist eine Vorrichtung zum Verfestigen von flüssigem Silizium bekannt.

Aus der US 4 661 335 ist ein Verfahren zum Herstellen von hochreinem Siliziumpulver bekannt.

Aus der US 2003/0175196 A1 ist ein Reaktor mit einem Katalysator zur Herstellung von HCN bekannt.

Der Erfindung liegt die Aufgabe zugrunde, einen Reaktor zur Zersetzung eines Silizium enthaltenden Gases derart weiterzubilden, dass dieser wirkungsvoll und einfach vor Beschädigungen durch abgelagertes Silizium geschützt wird und gleichzeitig hochreines Silizium zur Weiterverarbeitung in der Photovoltaik energie- und kostensparend herstellbar ist.

Diese Aufgabe wird durch die Merkmale der Ansprüche 1 und 13 gelöst. Der Kern der Erfindung besteht darin, dass mindestens ein gasdurchlässiges Katalysator-Element vorgesehen ist, das innerhalb der Reaktions-Kammer zwischen der mindestens einen Gas-Zuführ-Leitung und der Innen-Wand des Reaktor-Behälters angeordnet ist. Bedingt durch die katalytische Wirkung des Katalysator-Elements wird das thermische Zersetzen des Gases und das Abscheiden von pulverförmigem Silizium aus der Gas-phase beschleunigt und die Konzentration des Silizium enthaltenden Gases unmittelbar an der Innen-Wand des Reaktor-Behälters reduziert. Dies führt zu einer Reduzierung der Abscheidung von Silizium an der Innen-Wand des Reaktor-Behälters und infolge dessen zu einer deutlichen Erhöhung der Betriebszeit des Reaktors, da eine erforderliche Unterbrechung des kontinuierlichen Reaktorbetriebes zur Reinigung des Reaktor-Behälters nur noch in deutlich längeren Zeitabständen erfolgen muss. Weiterhin erfolgt aufgrund der katalytischen Wirkung des Katalysator-Elements die Zersetzung des Silizium enthaltenden Gases bei deutlich niedrigeren Temperaturen, wodurch eine Energieeinsparung möglich ist und der Wirkungsgrad des Reaktors verbessert wird. Weiterhin sind infolge der beschleunigten thermischen Zersetzung des Silizium enthaltenden Gases höhere Strömungsgeschwindigkeiten und höhere Konzentrationen des Gases in der Reaktions-Kammer möglich, wodurch die Raum-Zeit-Ausbeute des Reaktors verbessert und somit die Leistung des Reaktors erhöht wird.

Weitere vorteilhafte Ausgestaltungen der Erfindung ergeben sich aus den Unteransprüchen.

Zusätzliche Merkmale, Vorteile und Einzelheiten der Erfindung ergeben sich aus der nachfolgenden Beschreibung mehrerer Ausführungsbeispiele anhand der Zeichnungen. Es zeigen:
- Fig. 1: einen Längsschnitt durch einen Reaktor gemäß einem ersten Ausführungsbeispiel,
- Fig. 2: einen vergrößerten Ausschnitt eines Katalysator-Elements des Reaktors gemäß Fig. 1,
- Fig. 3: einen Längsschnitt durch einen Reaktor gemäß einem zweiten Ausführungsbeispiel, und
- Fig. 4: einen Längsschnitt durch einen Reaktor gemäß einem dritten Ausführungsbeispiel.

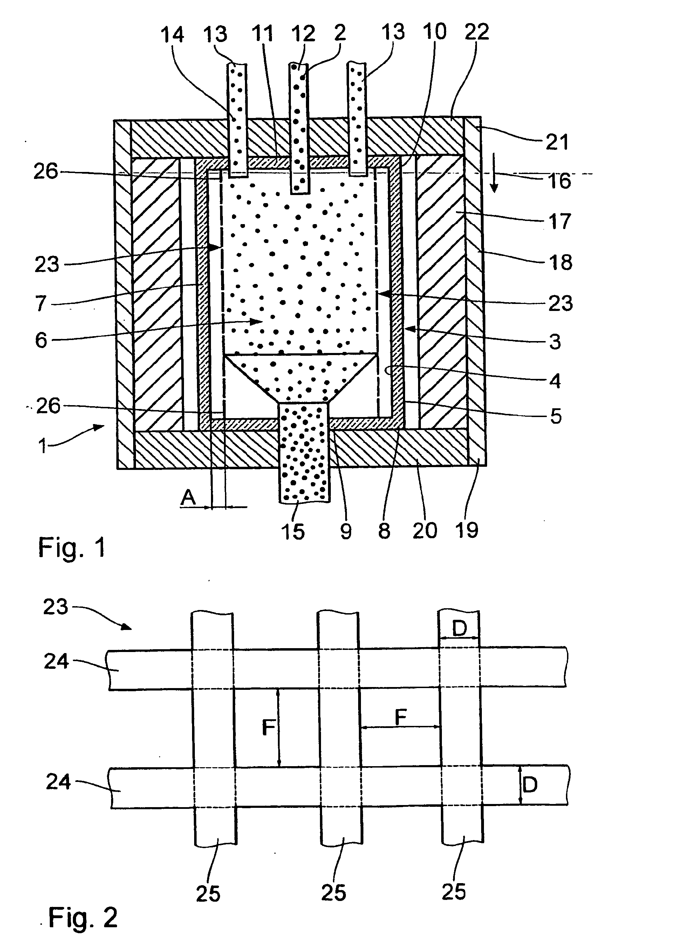

Im Folgenden wird unter Bezugnahme auf Figur 1 und 2 ein erstes Ausführungsbeispiel der Erfindung beschrieben. Ein Reaktor 1 zur Zersetzung eines Silizium enthaltenden Gases 2 weist zur Aufnahme des Gases 2 einen Reaktor-Behälter 3 vorzugsweise aus Quarzglas, Graphit, CFC oder SiC auf. Der Reaktor-Behälter 3 weist eine Innen-Wand 4 und eine AußenWand 5 auf, wobei die Innen-Wand 4 eine Reaktions-Kammer 6 umschließt. Der Reaktor-Behälter 3 wird durch einen im Wesentlichen hohlzylinderförmigen Seiten-Abschnitt 7, einen den Seiten-Abschnitt 7 an einem ersten Ende 8 verschließenden scheibenförmigen Boden-Abschnitt 9 und einen den Seiten-Abschnitt 7 an einem zweiten Ende 10 verschließenden scheibenförmigen Deckel-Abschnitt 11 ausgebildet. Zur Zuführung des Gases 2 in die Reaktions-Kammer 6 ist mittig zu dem Deckel-Abschnitt 11 eine diesen durchbrechende Gas-Zuführ-Leitung 12 angeordnet. Konzentrisch zu der Gas-Zuführ-Leitung 12 ist weiterhin eine ringförmige und den Deckel-Abschnitt 11 durchbrechende Hilfsgas-Zuführ-Leitung 13 zur Zuführung eines Hilfsgases 14 angeordnet. Gegenüberliegend zu der Gas-Zuführ-Leitung 12 ist mittig zu dem Boden-Abschnitt 9 eine diesen durchbrechende trichterförmige Gas-Abführ-Leitung 15 zur Abführung des nach der Zersetzung entstandenen pulverförmigen Siliziums und des restlichen Gases 2 angeordnet. Das durch die Gas-Zuführ-Leitung 12 in die Reaktions-Kammer 6 eingeleitete Gas 2 weist im Wesentlichen eine Einström-Richtung 16 auf, die senkrecht zu dem Deckel-Abschnitt 11 des Reaktor-Behälters 3 ist, wobei das Gas 2 durch das Hilfsgas 14 in Form eines Ringstromes umgeben ist.

Außerhalb der Reaktions-Kammer 6 ist der Reaktor-Behälter 3 von einer hohlzylinderförmigen Heiz-Vorrichtung 17 umgeben, die zur Beheizung der Reaktions-Kammer 6 elektrisch beheizbar ist. Die Heiz-Vorrichtung 17 ist vollflächig um den Seiten-Abschnitt 7 des Reaktor-Behälters 3 und beabstandet von diesem angeordnet.

Die Heiz-Vorrichtung 17 und der Reaktor-Behälter 3 sind zum Schutz vor Beschädigungen von einer Schutz-Hülle 18 umgeben, die hohlzylinderförmig ausgebildet ist und an einem ersten freien Ende 19 durch einen Schutz-Boden 20 und an einem zweiten freien Ende 21 durch einen Schutz-Deckel 22 verschlossen ist. Der Schutz-Deckel 22 wird zur Zuführung des Gases 2 und des Hilfsgases 14 von der Gas Zuführ-Leitung 12 und der Hilfsgas-Zuführ-Leitung 13 durchbrochen. Weiterhin wird der Schutz-Boden 20 zur Abführung des pulverförmigen Siliziums und des restlichen Gases 2 von der Gas-Abführ-Leitung 15 durchbrochen.

Innerhalb der Reaktions-Kammer 6 ist zwischen der Gas-Zuführ-Leitung 12 und der Innen-Wand 4 des Reaktor-Behälters 3 ein gasdurchlässiges Katalysator-Element 23 in Form eines elektrisch beheizbaren Gitters angeordnet. Das Gitter 23 ist in Form eines Hohlzylinders oder Zylindermantels ausgebildet und konzentrisch zu der Gas-Zuführ-Leitung 12 in der Reaktions-Kammer 6 ausgerichtet. Das Gitter 23 erstreckt sich vollflächig entlang dem Seiten-Abschnitt 7 des Reaktor-Behälters 3. Das Gitter 23 weist einen radialen Abstand A von der Innen-Wand 4 des Reaktor-Behälters 3 auf, der im Bereich von 1 mm bis 100 mm, insbesondere von 5 mm bis 60 mm, und insbesondere von 10 mm bis 50 mm, liegt. Die ringförmige Hilfsgas-Zuführ-Leitung 13 ist zwischen dem Gitter 23 und der Gas-Zuführ-Leitung 12 angeordnet, wobei der radiale Abstand von der Gas-Zuführ-Leitung 12 deutlich größer als der radiale Abstand von dem Gitter 23 ist.

Das Gitter 23 besteht aus mindestens einem Material, das bis zu einer Temperatur von mindestens 1200° C, insbesondere von mindestens 1600° C, und insbesondere von mindestens 2000° C, temperaturbeständig ist. Dieses Material wirkt als Katalysator und beschleunigt die Zersetzung des Gases 2. Vorteilhafterweise besteht das Gitter 23 aus einer Legierung oder einem Metall, insbesondere aus mindestens einem der Elemente Molybdän, Tantal, Niob und Wolfram. Diese Elemente weisen eine gute elektrische Leitfähigkeit in Verbindung mit einer hohen Schmelztemperatur auf und verunreinigen das aus der Gasphase entstehende pulverförmige Silizium nur gering mit einer Konzentration von < 0,1 ppma.

Das Gitter 23 ist aus mehreren beabstandet voneinander angeordneten Quer-Stäben 24 und mehreren senkrecht zu den Quer-Stäben 24 und beabstandet voneinander angeordneten Längs-Stäben 25 aufgebaut. Jeweils zwei benachbarte Quer-Stäbe 24 oder jeweils zwei benachbarte LängsStäbe 25 weisen einen freien Gitterabstand F auf, der im Bereich von 0,1 mm bis 10 mm, insbesondere von 0,5 mm bis 5 mm, und insbesondere von 0,9 mm bis 2 mm, liegt. Die Stäbe 24, 25 sind aus einem im Querschnitt kreisförmigen Draht ausgebildet, der einen Durchmesser D im Bereich von 0,1 mm bis 5 mm, insbesondere von 0,5 mm bis 3 mm, und insbesondere von 0,9 mm bis 2 mm, aufweist. Vorzugsweise ist das Gitter 23 ein Gewebe aus Draht oder ein Geflecht aus Draht.

Das Gitter 23 ist im Bereich seiner freien Gitterenden 26 mit Anschlüssen an die Pole einer nicht dargestellten Spannungsquelle angeschlossen. Die Anschlüsse sind in abgedichteter Weise in den Reaktor-Behälter 3 geführt. Durch den freien Gitterabstand F und den Durchmesser D sind der elektrische Widerstand des Gitters 23, die maximale Heizleistung des Gitters 23 und die Oberfläche des Gitters 23 im Verhältnis zueinander optimierbar.

Nach der Gas-Abführ-Leitung 15 ist zum Abtrennen des pulverförmigen Siliziums und zum Verdichten von diesem eine nicht dargestellte Entgasungs- und Verdichtungs-Vorrichtung angeordnet. Hinsichtlich des Aufbaus der Entgasungs- und Verdichtungs-Vorrichtung wird auf die DE 10 2004 027 563.7 und die DE 10 2004 027 564.5 verwiesen.

Im Folgenden wird die Funktionsweise des Reaktors 1 zur Herstellung von Silizium, das als Ausgangsstoff für die Fertigung von polykristallinen Siliziumblöcken oder Siliziumeinkristallen für die Photovoltaik geeignet ist, beschrieben. Durch die Gas-Zuführ-Leitung 12 wird in Einström-Richtung 16 das Silizium enthaltende Gas 2, beispielsweise Monosilan SiH₄ oder Trichlorsilan SiHCl₃, in die Reaktions-Kammer 6 eingeleitet. Durch die Einstellung der Einström-Geschwindigkeit ist die Verweildauer des Gases 2 und die Konzentration des Gases 2 innerhalb der Reaktions-Kammer 6 einstellbar.

Gleichzeitig zu dem Gas 2 wird durch die Hilfsgas-Zuführ-Leitung 13 das Hilfsgas 14, welches das Gas 2 im Wesentlichen ringförmig umgibt, in Einström-Richtung 16 eingeleitet, wobei das Hilfsgas 14 im Wesentlichen in Einström-Richtung 16 entlang des Gitters 23 und der Innen-Wand 4 strömt. Als Hilfsgas 14 wird beispielsweise ein Inertgas wie Argon Ar oder Wasserstoff H₂ oder Stickstoff N₂ verwendet. Die Reaktions-Kammer 6 ist beim Einleiten der Gase 2, 14 auf eine Betriebs-Temperatur T_{R} von 700° C bis 1200° C aufgeheizt. Weiterhin ist das Gitter 23 derart beheizt, dass dieses eine Temperatur T_{G} aufweist, die höher als eine Temperatur T_{I} an der Innen-Wand 4 in dem beheizten Seiten-Abschnitt 7 des Reaktor-Behälters 3 ist.

Das Gas 2 wird nach dem Einleiten in die Reaktions-Kammer 6 thermisch zersetzt und es wird aus der Gasphase pulverförmiges Silizium abgeschieden. Das abgeschiedene pulverförmige Silizium weist eine Reinheit derart auf, dass es zur Herstellung von Siliziumschmelze für die Fertigung von polykristallischen Siliziumblöcken oder Siliziumeinkristallen für die Photovoltaik geeignet ist. Das pulverförmige Silizium besteht aus Silizium-Teilchen, die einen mittleren Durchmesser von 0,1 µm bis 20 µm, insbesondere von 2 µm bis 5 µm, aufweisen. Durch die Einstellung der Verweildauer des Gases 2 und der abgeschiedenen Silizium-Teilchen mittels der Einström-Geschwindigkeit ist der mittlere Durchmesser der Silizium-Teilchen einstellbar.

Das in Einström-Richtung 16 zugeführte Gas 2 verteilt sich im Wesentlichen gleichmäßig innerhalb der Reaktions-Kammer 6 und passiert zu einem Teil das Gitter 23. Aufgrund der katalytischen Wirkung des Gitters 23 kommt es im Bereich um das Gitter 23, insbesondere beim Passieren von diesem, zu einem beschleunigten thermischen Zersetzen des Gases 2. Dieser Vorgang wird zusätzlich durch die im Vergleich zu der Temperatur T_{R} in der Reaktions-Kammer 6 und der Temperatur T_{I} der Innen-Wand 4 höhere Temperatur T_{G} des Gitters 23 beschleunigt. Aufgrund der Tatsache, dass sich das aus der Gasphase abgeschiedene pulverförmige Silizium bevorzugt an der heißesten Oberfläche ablagert, kommt es infolge der im Vergleich zu der Temperatur T_{I} der Innen-Wand 4 höheren Temperatur T_{G} des Gitters 23 zu einer deutlichen Reduzierung des sich an der Innen-Wand 4 ablagernden Siliziums. Zudem ist aufgrund der beschleunigten Zersetzung des Gases 2 in radialer Richtung vor dem Gitter 23 und beim Passieren des Gitters 23, die Konzentration des Gases 2 zwischen dem Gitter 23 und der Innen-Wand 4 deutlich reduziert, was die Reduzierung von auf der Innen-Wand 4 sich ablagernden Silizium-Teilchen ebenfalls begünstigt.

Aufgrund des katalytisch wirkenden Materials des Gitters 23 findet die thermische Zersetzung des Gases 2 bereits bei einer geringeren Temperatur statt, was in Verbindung mit der unmittelbaren Wärmeeinkopplung durch das Gitter 23 in die Reaktions-Kammer 6 zu einem geringen Energieverbrauch führt. Aufgrund der beschleunigten Zersetzung des Gases 2 wird die Raum-Zeit-Ausbeute und somit die Leistung des Reaktors 1 verbessert. Die deutliche Reduzierung der Ablagerung von Silizium-Teilchen an der Innen-Wand 4 des Reaktor-Behälters 3 ermöglicht eine deutliche Verlängerung der Betriebsdauer des Reaktors 1, ohne dass der kontinuierliche Betrieb des Reaktors 1 durch eine erforderliche Reinigung des Reaktor-Behälters 3 unterbrochen werden muss. Ferner wird der Reaktor-Behälter 3 wirkungsvoll vor Beschädigungen durch die sich ablagernden Silizium-Teilchen geschützt.

Durch das ringförmige Einströmen des Hilfsgases 14, welches das Gas 2 umgibt, wird die Konzentration des Gases 2 im Bereich des Gitters 23 und der Innen-Wand 4 zusätzlich reduziert, sodass auch dadurch die Anzahl sich ablagernder Silizium-Teilchen reduziert wird.

Nach dem thermischen Zersetzen des Gases 2 wird das pulverförmige Silizium und das restliche Gas 2 durch die Gas-Abführ-Leitung 15 aus der Reaktions-Kammer 6 ausgeleitet und zum Abtrennen und Verdichten des gebildeten pulverförmigen Siliziums der Entgasungs- und Verdichtungs-Vorrichtung zugeführt. Für einen detaillierte Beschreibung der Funktionsweise der Entgasungs- und Verdichtungs-Vorrichtung wird auf die DE 10 2004 027 563.7 und auf die DE 10 2004 027 564.5 verwiesen.

Das hergestellte pulverförmige Silizium hat eine braune Farbe und weist Silizium-Teilchen mit einem mittleren Durchmesser von 0,1 µm bis 20 µm, insbesondere von 2 µm bis 5µm, auf. Das hergestellten pulverförmige Silizium kann entweder direkt für die Fertigung von polykristallinen Siliziumblöcken oder Siliziumeinkristallen für die Photovoltaik eingeschmolzen werden oder nach dem Einschmelzen formgebend behandelt, insbesondere zu einem Granulat verarbeitet werden.

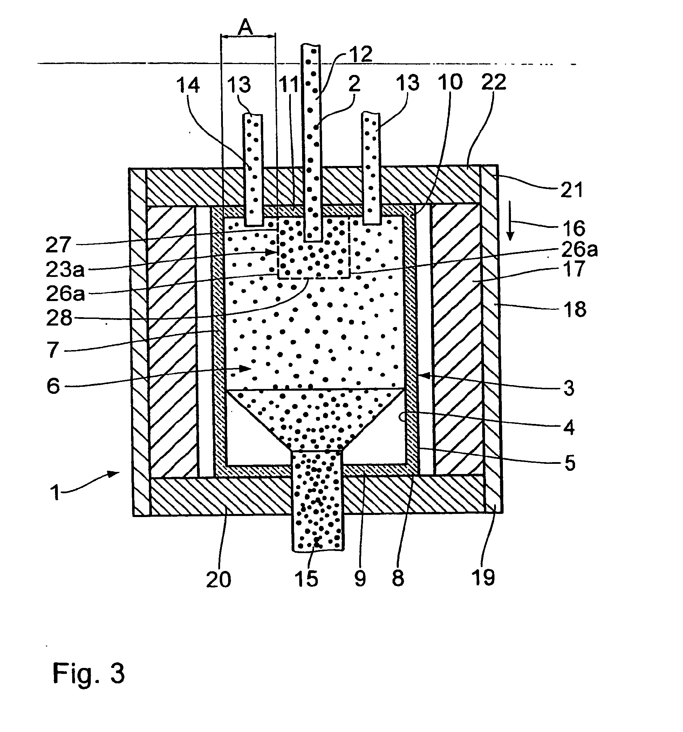

Im Folgenden wird unter Bezugnahme auf die Figur 3 ein zweites Ausführungsbeispiel der Erfindung beschrieben. Konstruktiv identische Teile erhalten dieselben Bezugszeichen, wie bei dem ersten Ausführungsbeispiel, auf dessen Beschreibung hiermit verwiesen wird. Konstruktiv unterschiedliche, jedoch funktionell gleichartige Teile erhalten dieselben Bezugszeichen mit einem nachgestellten "a". Der wesentliche Unterschied gegenüber dem ersten Ausführungsbeispiel besteht in der Ausgestaltung und Anordnung des Gitters 23a. Das Gitter 23a ist derart ausgebildet, dass es die Gas-Zuführ-Leitung 12 vollständig umschließt. Hierzu weist das Gitter 23a einen hohlzylinderförmig ausgebildeten ersten Gitter-Abschnitt 27 auf, der konzentrisch zu der Gas-Zuführ-Leitung 12 und zwischen der Gas-Zuführ-Leitung 12 und der Hilfsgas-Zufiihr-Leitung 13 angeordnet ist. Der erste Gitter-Abschnitt 27 erstreckt sich in Einström-Richtung 16 ungefähr bis zu einem Drittel der Reaktions-Kammer 6 und weist im Vergleich zu dem ersten Ausführungsbeispiel einen deutlich größeren radialen Abstand A zu der Innen-Wand 4 des Reaktor-Behälters 3 auf. Der erste Gitter-Abschnitt 27 ist an dem dem Deckel-Abschnitt 11 des Reaktor-Behälters 3 abgewandten Gitterende 26a durch einen im Wesentlichen scheibenförmigen zweiten Gitter-Abschnitt 28 abgeschlossen. Das Gitter 23a ist derart ausgestaltet, dass es elektrisch beheizbar ist. Zur elektrischen Beheizung des Gitters 23a ist dieses mit den Polen einer nicht dargestellten Spannungsquelle verbunden.

Nach dem Zuführen des Silizium enthaltenden Gases 2 in die Reaktions-Kammer 6 beginnt das thermische Zersetzen des Gases 2 und das Abscheiden von pulverförmigem Silizium aus der Gasphase. Durch die Anordnung des Gitters 23a um die Gas-Zuführ-Leitung 12 muss das Gas 2 vollständig das Gitter 23a passieren. Aufgrund der Temperatur T_{G} des Gitters 23a und des katalytisch wirkenden Materials des Gitters 23a erfolgt die thermische Zersetzung des Gases 2 beschleunigt und im Wesentlichen beim Passieren des Gitters 23a. Die Konzentration des Gases 2 ist somit nach dem Passieren des Gitters 23a deutlich verringert, sodass die Abscheidung des Siliziums aus dem Gas 2 an der Innen-Wand 4 reduziert wird. Die Konzentration des Silizium enthaltenden Gases 2 wird zusätzlich durch die ringförmige Zuführung des Hilfsgases 14 im Bereich der Innen-Wand 4 reduziert. Weiterhin wird aufgrund der im Vergleich zu der Temperatur T_{G} des Gitters 23a niedrigeren Temperatur T_{I} der Innen-Wand 4 die Ablagerung von Silizium an der Innen-Wand 4 ebenfalls verringert.

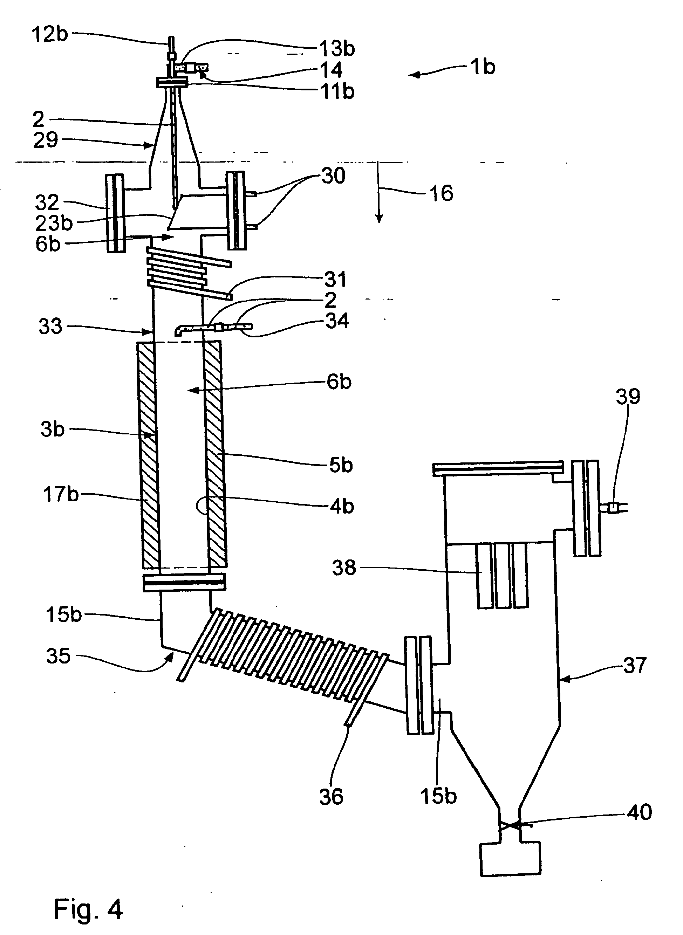

Im Folgenden wird unter Bezugnahme auf die Fig. 4 ein drittes Ausführungsbeispiel der Erfindung beschrieben. Konstruktiv identische Teile erhalten dieselben Bezugszeichen wie bei dem ersten Ausführungsbeispiel, auf dessen Beschreibung hiermit verwiesen wird. Konstruktiv unterschiedliche, jedoch funktionell gleichartige Teile erhalten dieselben Bezugszeichen mit einem nachgestellten "b". Der wesentliche Unterschied gegenüber den vorangegangenen Ausführungsbeispielen besteht im Aufbau des Reaktors 1b und in der Anordnung des Katalysator-Elements 23b.

Der Reaktor 1b ist prinzipiell in drei Abschnitte gegliedert. In einem Zuführungs-Abschnitt 29 ist das Katalysator-Element 23b (SiH₄, H₂, N₂, He) in dem Reaktor-Behälter 3b angeordnet. Die Gas-Zuführ-Leitung 12b und die Hilfsgas-Zuführ-Leitung 13b (H₂, N₂, He) münden in den Zuführungs-Abschnitt 29 des Reaktor-Behälters 3b, wobei sich die Gas-Zuführ-Leitung 12b bis zu dem Katalysator-Element 23b erstreckt, so dass das eingeleitete Silizium enthaltende Gas 2 direkt auf das Katalysator-Element 23b trifft. Das Katalysator-Element 23b ist schräg zu der Einström-Richtung 16 angeordnet und als Gitter ausgebildet. Das Katalysator-Element 23b ist mittels elektrisch leitfähiger Katalysator-Element-Anschlüsse 30 an dem Reaktor-Behälter 3b befestigt, wobei die Katalysator-Element-Anschlüsse 30 aus dem Reaktor Behälter 3b herausgeführt sind und zur elektrischen Beheizung des Katalysator-Elements 23b mit einer nicht näher dargestellten Spannungsquelle verbindbar sind. Im Bereich des Zuführungs-Abschnitts 29 ist weiterhin ein erstes Kühl-Element 31 angeordnet, das dem Katalysator-Element 23b in Einström-Richtung 16 nachgeordnet ist. Das erste Kühl-Element 31 ist als Wasser-Rohrleitung ausgebildet und umgibt den Reaktor-Behälter 3b spulenförmig. Zur Überwachung des Katalysator-Elements 23b weist der Reaktor-Behälter 3b ein Schauglas 32 auf, das im Bereich des Katalysator-Elements 23b angeordnet ist.

Dem Zuführungs-Abschnitt 29 ist in Einström-Richtung 16 ein Reaktions-Abschnitt 33 nachgeordnet. Der Reaktions-Abschnitt 33 des Reaktor-Behälters 3b weist eine weitere Gas-Zuführ-Leitung 34 (SiH₄, H₂, N₂, He) auf, die seitlich in den Reaktor-Behälter 3b mündet. Der Gas-Zuführ-Leitung 34 ist in Einström-Richtung 16 die Heiz-Vorrichtung 17b zur Beheizung der Reaktions-Kammer 6b im Bereich des Reaktions-Abschnitts 33 nachgeordnet. Der Abstand des Katalysator-Elements 23b zu der Heiz-Vorrichtung 17b beträgt zwischen 1 mm und 500 mm, insbesondere zwischen 5 mm und 200 mm, und insbesondere zwischen 10 mm und 100 mm.

Dem Reaktions-Abschnitt 33 ist in Einström-Richtung 16 ein Abführungs-Abschnitt 35 nachgeordnet, der von einem zweiten Kühl-Element 36 umgeben ist. Das zweite Kühl-Element 36 ist ebenfalls als Wasser-Rohrleitung ausgebildet und umgibt den Abführungs-Abschnitt 35 des Reaktor-Behälters 3b spulenförmig. Dem Abführungs-Abschnitt 35 schließt sich die Gas-Abführ-Leitung 15b an, die in eine Entgasungs-Vorrichtung 37 mündet. Die Entgasungs-Vorrichtung 37 dient zum Abtrennen des erzeugten pulverförmigen Siliziums von dem Restgas. Zum Abtrennen und Abführen des Restgases sind Filter-Elemente 38 und eine Restgas-Abführ-Leitung 39 vorgesehen. Zum Austragen des abgetrennten Siliziums ist weiterhin ein Ventil 40 vorgesehen.

Nachfolgend wird die Funktionsweise des Reaktors 1b näher beschrieben. Das Silizium enthaltende Gas 2 und das Hilfsgas 14 wird mittels der Gas-Zuführ-Leitung 12b und der Hilfsgas-Zuführ-Leitung 13b in den Zuführungs-Abschnitt 29 des Reaktor-Behälters 3b eingeleitet, wobei das Hilfsgas 14 entlang der Innen-Wand 4b strömt. Das Gas 2 trifft auf das elektrisch beheizte Katalysator-Element 23b, wo es in einen aktivierten Zustand übergeht. Ein thermisches Zersetzen des Silizium enthaltenden Gases 2 findet in diesem Teil der Reaktions-Kammer 6b, das heißt im Zuführungs-Abschnitt 29, im Wesentlichen nicht statt. Mittels des ersten Kühl-Elements 31 wird der Zuführungs-Abschnitt 29 gekühlt und von dem nachgeordneten Reaktions-Abschnitt 33 im Wesentlichen thermisch entkoppelt. Die mittlere Temperatur des Gases 2 beträgt im Bereich der Reaktor-Kammer 6b weniger als 800°C, insbesondere weniger als 650°C, und insbesondere weniger als 500°C.

Das einen aktivierten Zustand aufweisende Gas 2 wird mittels der weiteren Gas-Zuführ-Leitung 34 mit weiterem Silizium enthaltenden Gas 2 vermischt. Dieses im Reaktions-Abschnitt 33 zugeführte Gas 2 befindet sich zunächst in einem nicht aktivierten Zustand. Die Heiz-Vorrichtung 17b weist eine Temperatur von über 600°C, insbesondere von über 700°C, und insbesondere von über 800°C auf. Dadurch, dass das Silizium enthaltende Gas 2 sich teilweise in einem aktivierten Zustand befindet, setzt aufgrund dieser Temperatur das thermische Zersetzen des Gases 2 ein, wobei die thermische Zersetzung in Folge des mittels des Katalysator-Elements 23b erzeugten aktivierten Zustandes schneller und bei einer niedrigeren Temperatur erfolgt, als bei herkömmlichen Reaktoren.

Das abgeschiedene Silizium und das Restgas werden über den Abführungs-Abschnitt 35 und die Gas-Abführ-Leitung 15b in die Entgasungs- und Verdichtungs-Vorrichtung 37 eingeleitet, wo das pulverförmige Silizium von dem Restgas getrennt wird. Mittels des zweiten Kühl-Elements 36 wird das pulverförmige Silizium und das Restgas vor dem Eintritt in die Entgasungs- und Verdichtungs-Vorrichtung 37 gekühlt.

Dadurch, dass das Katalysator-Element 23b in dem gekühlten Zuführungs-Abschnitt 29 angeordnet und von der Heiz-Vorrichtung 17b beabstandet ist, wird ein Kontakt des Katalysator-Elements 23b mit abgeschiedenem pulverförmigen Silizium vermieden, so dass die Stabilität und Aktivität des Katalysator-Elements 23b für einen deutlich längeren Zeitraum erhalten bleibt, als bei einer Anordnung des Katalysator-Elements 23b unmittelbar im Bereich der Heiz-Vorrichtung 17b. Durch das Überführen eines Teils des Silizium enthaltenden Gases 2 in einen aktivierten Zustand mittels des Katalysator-Elements 23b wird das Abscheiden von pulverförmigem Silizium aus der Gasphase beschleunigt, so dass die Raum-Zeit-Ausbeute des Reaktors 1b und somit die Leistung des Reaktors 1b erhöht wird. Dadurch, dass die thermische Zersetzung bereits bei einer Temperatur stattfindet, wird eine Energieeinsparung erzielt und der Wirkungsgrad des Reaktors 1b verbessert. Ferner wird die Ablagerung von Silizium an der Innen-Wand 4b des Reaktor-Behälters 3b reduziert.

In weiteren Ausführungsbeispielen kann der Gas-Zuführ-Leitung 34 eine weitere Hilfsgas-Zuführ-Leitung zugeordnet sein. Alternativ kann die zweite Gas-Zuführ-Leitung 34 auch entfallen und das Silizium enthaltende Gas 2 vollständig mittels der ersten Gas-Zuführ-Leitung 12b eingeleitet werden. Prinzipiell können auch mehrere verschiedene Silizium enthaltende Gase 2 und mehrere verschiedene Hilfsgase 14 verwendet werden.

Weiterhin können in allen Ausführungsbeispielen die Gas-Zuführ-Leitungen mit einer zusätzlichen Kühlung ausgestattet sein, insbesondere mit einer Wasserkühlung. Die Gas-Zuführ-Leitungen können als Rohr oder als Düse, insbesondere als Einstoffdüse oder als Mehrstoffdüse, ausgebildet sein. Vorteilhaft ist eine Ausbildung als Zweistoffdüse, wobei das Silizium enthaltende Gas bevorzugt innen geführt wird.

Das Katalysator-Element kann prinzipiell beliebig zweidimensional oder dreidimensional ausgebildet sein, sofern es gasdurchlässig ist. Beispielsweise kann das Katalysator-Element als Gitter, als Rohr, als Topf oder als Halbkugel ausgebildet sein. Weiterhin ist es möglich, dass mehrere Katalysator-Elemente übereinander, nacheinander und/oder nebeneinander angeordnet sind, wobei jedes Katalysator-Element mit einer eigenen Spannungsquelle verbunden sein kann, so dass die Katalysator-Elemente mit unterschiedlichen oder identischen Temperaturen betrieben werden können. Weiterhin kann das Katalysator-Element als Monolith mit einer Wabenstruktur ausgebildet sein, wobei das Silizium enthaltende Gas mit oder ohne dem Hilfsgas durch die Wabenstruktur strömt. Vorteilhaft ist auch eine Ausbildung des Katalysator-Elements als Lochplatte oder poröse Platte, so dass ein möglichst inniger Kontakt zwischen dem Silizium enthaltenden Gas und dem Katalysator-Element erzielt wird.

Weiterhin kann das Katalysator-Element mit der Gas-Zuführ-Leitung bündig abschließen oder innerhalb der Gas-Zuführ-Leitung, insbesondere 1 mm bis 100 mm, insbesondere 2 mm bis 80 mm, und insbesondere 5 mm bis 50 mm innerhalb der Gas-Zuführ-Leitung, angeordnet sein.

Das erfindungsgemäße Verfahren kann so betrieben werden, dass die Silizium-Teilchen einen mittleren Durchmesser von 0,1 µm bis 20 µm, insbesondere von 2 µm bis 5 µm aufweisen. Das Verfahren kann jedoch auch anders gesteuert werden, so dass Silizium-Teilchen mit einem größeren Durchmesser, beispielsweise von 5 µm bis 200 µm, insbesondere von 20 µm bis 120 µm erzeigt werden. Hierbei handelt es sich um zwei voneinander verschiedene Möglichkeiten, das erfindungsgemäße Verfahren zu betreiben.

Weitere Ausführungsbeispiele des Reaktors können um 180 ° gedreht sein, sodass die Gas-Zuführ-Leitung und die Hilfsgas-Zuführ-Leitung im Boden-Abschnitt und die Gas-Abführ-Leitung im Deckel-Abschnitt angeordnet sind. Die Einström-Richtung des Silizium enthaltenden Gases und des Hilfsgases ist bei diesen Ausführungsbeispielen entgegen die Schwerkraft gerichtet. Dadurch, dass die Einström-Richtung der Gas-Zuführ-Leitung entgegen die Schwerkraft gerichtet ist, muss das Einleiten des Gases mit einer Einström-Geschwindigkeit derart erfolgen, dass die Schwerkraft auf das Gas überwunden wird. Durch die Einstellung der Einström-Geschwindigkeit ist die Verweildauer des Gases und die Konzentration des Gases innerhalb des Reaktions-Kammer einstellbar. Hinsichtlich des weiteren Aufbaus und der Funktionsweise wird auf die vorangegangenen Ausführungsbeispiele verwiesen.

## Patentansprüche

1. Reaktor (1; 1a; 1b) zur Zersetzung eines Silizium enthaltenden Gases (2), umfassend
a. einen Reaktor-Behälter (3; 3b) mit
i. einer von einer Innen-Wand (4; 4b) umschlossenen Reaktions-Kammer (6; 6b) zur Aufnahme eines Silizium enthaltenden Gases (2),
ii. mindestens einer Gas-Zuführ-Leitung (12; 12b) zur Zuführung des Gases (2) in die Reaktions-Kammer (6; 6b) und
iii. einer ringförmigen, konzentrisch zu der Gas-Zuführ-Leitung (12; 12b) angeordneten Hilfsgas-Zuführ-Leitung (13) zur Zuführung eines Inertgases (14),
b. mindestens eine außerhalb der Reaktions-Kammer (6; 6b) angeordnete Heiz-Vorrichtung (17; 17b) zur Beheizung der Reaktions-Kammer (6; 6b), und
c. mindestens ein gasdurchlässiges Katalysator-Element (23; 23a; 23b), das innerhalb der Reaktions-Kammer (6; 6b) zwischen der mindestens einen Gas-Zuführ-Leitung (12; 12b) und der Innen-Wand (4; 4b) des Reaktor-Behälters (3; 3b) angeordnet ist und mindestens ein Material aufweist, das als Katalysator wirkend die Zersetzung des Gases (2) beschleunigt.

2. Reaktor nach Anspruch 1, **dadurch gekennzeichnet, dass** das mindestens eine Katalysator-Element (23a) derart ausgebildet ist, dass es die mindestens eine Gas-Zuführ-Leitung (12) vollständig umschließt.

3. Reaktor nach Anspruch 2, **dadurch gekennzeichnet, dass** die mindestens eine Hilfsgas-Zuführ-Leitung (13) zur Zuführung des Inertgases (14) zwischen der Innen-Wand (4) und dem mindestens einen Katalysator-Element (23a) angeordnet ist.

4. Reaktor nach einem der Ansprüche 1 bis 3, **dadurch gekennzeichnet, dass** das mindestens eine Katalysator-Element (23; 23a; 23b) elektrisch beheizbar ist.

5. Reaktor nach Anspruch 4, **dadurch gekennzeichnet, dass** die Temperatur T_{G} des Katalysator-Elements (23; 23a; 23b) höher ist als die Temperatur T_{I} an der Innen-Wand (4; 4b).

6. Reaktor nach einem der vorangehenden Ansprüche, **dadurch gekennzeichnet, dass** das mindestens eine Katalysator-Element (23; 23a; 23b) aus mindestens einem Material besteht, das bis zu einer Temperatur von mindestens 1200° C, insbesondere von mindestens 1600 °C und insbesondere von mindestens 2000° C temperaturbeständig ist.

7. Reaktor nach einem der vorangehenden Ansprüche, **dadurch gekennzeichnet, dass** das mindestens eine Katalysator-Element (23; 23a; 23b) aus einem Metall, insbesondere mindestens eines der Elemente Molybdän, Tantal, Niob und Wolfram enthaltend, besteht.

8. Reaktor nach einem der vorangehenden Ansprüche, **dadurch gekennzeichnet, dass** sich das mindestens eine Katalysator-Element (23) zumindest vollflächig entlang eines Abschnitts (7) des Reaktor-Behälters (3) erstreckt, der durch die mindestens eine Heiz-Vorrichtung (17) beheizt wird.

9. Reaktor nach einem der Ansprüche 1 bis 8, **dadurch gekennzeichnet, dass** zwischen dem mindestens einen Katalysator-Element (23b) und der Heiz-Vorrichtung (17b) mindestens ein Kühl-Element (31) angeordnet ist.

10. Reaktor nach einem der Ansprüche 1 bis 9, **dadurch gekennzeichnet, dass** das mindestens eine Katalysator-Element (23b) entlang einer Einström-Richtung (16) des Silizium enthaltenden Gases (2) einen Abstand im Bereich von 1 mm bis 500 mm, insbesondere von 5 mm bis 200 mm, und insbesondere von 10 mm bis 100 mm zu der Heiz-Vorrichtung (17b) aufweist.

11. Reaktor nach einem der Ansprüche 1 bis 10, **dadurch gekennzeichnet, dass** der Reaktor (1b) derart ausgebildet ist, dass das Silizium enthaltende Gas (2) im Bereich der Reaktions-Kammer (6; 6b) eine mittlere Temperatur von weniger als 800°C, insbesondere von weniger als 650°C, und insbesondere von weniger als 500°C aufweist.

12. Reaktor gemäß einem der vorangehenden Ansprüche, **dadurch gekennzeichnet, dass** zwischen dem mindestens einen Katalysator-Element (23b) und der mindestens einen Heiz-Vorrichtung (17b) eine weitere Gas-Zuführ-Leitung (34) zur Zuführung eines Silizium enthaltenden Gases angeordnet ist.

13. Verfahren zur Herstellung von Silizium, das als Ausgangsstoff für die Fertigung von polykristallinen Siliziumblöcken oder Siliziumeinkristallen für die Photovoltaik geeignet ist, umfassend die folgenden Schrite:
a. Bereitstellen eines Reaktors (1; 1a; 1b) zur Zersetzung eines Silizium enthaltenden Gases (2), umfassend
i. einen Reaktor-Behälter (3; 3b) mit einer von einer Innen-Wand (4; 4b) umschlossenen Reaktions-Kammer (6; 6b) zur Aufnahme eines Silizium enthaltenden Gases (2), mindestens einer Gas-Zuführ-Leitung (12; 12b) zur Zuführung des Gases (2) in die Reaktions-Kammer (6; 6b) und einer die Gas-Zuführ-Leitung (12) ringförmig umgebenden Hilfsgas-Zuführ-Leitung (13) zur Zuführung eines Inertgases (14),
ii. mindestens eine außerhalb der Reaktions-Kammer (6; 6b) angeordnete Heiz-Vorrichtung (17; 17b) zur Beheizung der Reaktions-Kammer (6; 6b), und
iii. mindestens ein gasdurchlässiges Katalysator-Element (23; 23a; 23b), das innerhalb der Reaktions-Kammer (6; 6b) zwischen der mindestens einen Gas-Zuführ-Leitung (12; 12b) und der Innen-Wand (4; 4b) des Reaktor-Behälters (3; 3b) angeordnet ist und mindestens ein Material aufweist, das als Katalysator wirkend die Zersetzung des Gases (2) beschleunigt,
b. Zuführen des Silizium enthaltenden Gases (2) in die Reaktions-Kammer (6; 6b) derart, dass zumindest ein Teil des Gases (2) das mindestens eine Katalysator-Element (23; 23a; 23b) passiert,
c. thermisches Zersetzen des zugeführten Gases (2) unter Bildung von Silizium, und
d. Abtrennen des gebildeten Siliziums von dem Gas (2).

14. Verfahren zur Herstellung von Silizium nach Anspruch 13, **dadurch gekennzeichnet, dass** das mindestens eine Katalysator-Element (23; 23a; 23b) mindestens bis zu einer Temperatur (T_{G}) beheizt wird, die im Vergleich zu einer Temperatur (T_{I}) der Innen-Wand (4, 4b) größer ist.

15. Verfahren zur Herstellung von Silizium nach Anspruch 13 oder 14, **dadurch gekennzeichnet, dass** das Silizium enthaltende Gas (2) nach dem Passieren des mindestens einen Katalysator-Elements (23b) und vor dem thermischen Zersetzen mittels mindestens einem Kühl-Element (31) gekühlt wird.

16. Verfahren zur Herstellung von Silizium nach einem der Ansprüche 13 bis 15, **dadurch gekennzeichnet, dass** das Silizium enthaltende Gas (2) beim Passieren des mindestens einen Katalysator-Elements (23b) eine mittlere Temperatur von weniger als 800°C, insbesondere von weniger als 650°C, und insbesondere von weniger als 500°C aufweist.

17. Verfahren nach Anspruch 13, **dadurch gekennzeichnet, dass** zwischen dem mindestens einen Katalysator-Element (23b) und der mindestens einen Heiz-Vorrichtung (17b) erneut Silizium enthaltendes Gas (2) dem Reaktor-Behälter (3b) zugeführt wird.

## Claims

1. Reactor (1; 1a; 1b) for the decomposition of a silicon-containing gas (2), comprising
a. a reactor vessel (3; 3b) having
i. a reaction chamber (6; 6b) for receiving a silicon-containing gas (2), wherein the reaction chamber (6; 6b) is surrounded by an inner wall (4; 4b),
ii. at least one gas feed line (12; 12b) for feeding the gas (2) into the reaction chamber (6; 6b), and
iii. an annular auxiliary gas feed line (13), being arranged concentrically to the gas feed line (12; 12b), for feeding an inert gas (14),
b. at least one heating device (17; 17b) for heating the reaction chamber (6; 6b), wherein the at least one heating device (17; 17b) is arranged outside the reaction chamber (6; 6b), and
c. at least one gas-permeable catalyst element (23; 23a; 23b) which is arranged within the reaction chamber (6; 6b) between the at least one gas feed line (12; 12b) and the inner wall (4; 4b) of the reactor vessel (3; 3b) and has at least one material which, acting as a catalyst, accelerates the decomposition of the gas (2).

2. Reactor according to claim 1, **characterised in that** the at least one catalyst element (23a) is configured so as to surround the at least one gas feed line (12).

3. Reactor according to claim 2, **characterised in that** the at least one auxiliary gas feed line (13) for feeding the inert gas (14) is arranged between the inner wall (4) and the at least one catalyst element (23a).

4. Reactor according to claims 1 to 3, **characterised in that** the at least one catalyst element (23; 23a; 23b) is electrically heatable.

5. Reactor according to claim 4, **characterised in that** the temperature T_{G} of the catalyst element (23; 23a; 23b) is greater than the temperature T_{I} of the inner wall (4, 4b).

6. Reactor according to one of the preceding claims, **characterised in that** the at least one catalyst element (23; 23a; 23b) consists of at least one material which is thermally stable up to a temperature of at least 1,200 °C, in particular of at least 1,600 °C and especially of at least 2,000 °C.

7. Reactor according to one of the preceding claims, **characterised in that** the at least one catalyst element (23; 23a; 23b) consists of a metal, in particular a metal containing at least one of the elements molybdenum, tantalum, niobium and tungsten.

8. Reactor according to one of the preceding claims, **characterised in that** the at least one catalyst element (23) extends at least over its entire surface area along a portion (7) of the reactor vessel (3) that is heated by the at least one heating device (17).

9. Reactor according to any one of claims 1 to 8, **characterised in that** at least one cooling element (31) is arranged between the at least one catalyst element (23b) and the heating device (17b).

10. Reactor according to any one of claims 1 to 9, **characterised in that** the at least one catalyst element (23b) is at a distance from the heating device (17b) in the range of from 1 mm to 500 mm, in particular from 5 mm to 200 mm and especially from 10 mm to 100 mm along an inflow direction (16) of the silicon-containing gas (2).

11. Reactor according to any one of claims 1 to 10, **characterised in that** the reactor (1b) is configured in such a way that the silicon-containing gas (2) in the region of the reaction chamber (6; 6b) has an average temperature of less than 800 °C, in particular of less than 650 °C and especially of less than 500 °C.

12. Reactor according to any one of the preceding claims, **characterised in that** a further gas feed line (34) for feeding a silicon-containing gas is arranged between the at least one catalyst element (23b) and the at least one heating device (17b).

13. Process for the preparation of silicon which is suitable as a starting material for the production of polycrystalline silicon blocks or silicon monocrystals for photovoltaics, including the following steps:
a. providing a reactor (1; 1a; 1b) for the decomposition of a silicon-containing gas (2), comprising
i. a reactor vessel (3; 3b) having a reaction chamber (6; 6b) for receiving a silicon-containing gas (2) and at least one gas feed line (12; 12b) for feeding the gas (2) into the reaction chamber (6; 6b), wherein the reaction chamber (6; 6b) is surrounded by an inner wall (4; 4b), and an auxiliary gas feed line (13) for feeding an inert gas (14), annularly surrounding the gas fed line (12),
ii. at least one heating device (17; 17b) for heating the reaction chamber (6; 6b), wherein the at least one heating device (17; 17b) is arranged outside the reaction chamber (6; 6b), and
iii. at least one gas-permeable catalyst element (23; 23a; 23b) which is arranged within the reaction chamber (6; 6b) between the at least one gas feed line (12; 12b) and the inner wall (4; 4b) of the rector vessel (3; 3b) and has at least one material which, acting as a catalyst, accelerates the decomposition of the gas (2),
b. feeding the silicon-containing gas (2) into the reaction chamber (6; 6b) in such a way that at least a part of the gas (2) passes the at least one catalyst element (23; 23a; 23b),
c. thermally decomposing the fed gas (2) so as to form silicon, and
d. separating from the gas (2) the silicon formed.

14. Process for the preparation of silicon according to claim 13, **characterised in that** the at least one catalyst element (23; 23a; 23b) is heated at least up to a temperature (T_{G}) which is greater than a temperature (T_{I}) of the inner wall (4, 4b).

15. Process for the preparation of silicon according to either claim 13 or claim 14, **characterised in that** the silicon-containing gas (2) is cooled using at least one cooling element (31) after passing the at least one catalyst element (23b) and before the thermal decomposition.

16. Process for the preparation of silicon according to any one of claims 13 to 15, **characterised in that** the silicon-containing gas (2) has an average temperature of less than 800 °C, in particular of less than 650 °C and especially of less than 500 °C while passing the at least one catalyst element (23b).

17. Process according to claim 13, **characterised in that** silicon-containing gas (2) is again fed to the reactor vessel (3b) between the at least one catalyst element (23b) and the at least one heating device (17b).

## Revendications

1. Réacteur (1 ; 1a ; 1b) pour la décomposition d'un gaz (2) contenant du silicium, comportant
a. un récipient (3 ; 3b) avec
i. une chambre de réaction (6 ; 6b), entourée par une paroi intérieure (4 ; 4b) et destinée à recevoir un gaz (2) contenant du silicium,
ii. au moins une conduite d'admission du gaz (12 ; 12b) pour acheminer le gaz (2) dans la chambre de réaction (6 ; 6b), et
iii. une conduite d'admission de gaz auxiliaire (13) annulaire, disposée concentriquement à la conduite d'admission du gaz (12 ; 12b) et destinée à acheminer un gaz inerte (14),
b. au moins un dispositif de chauffage (17 ; 17b), disposé à l'extérieur de la chambre de réaction (6 ; 6b) et destiné à chauffer la chambre de réaction (6 ; 6b), et
c. au moins un élément catalyseur (23 ; 23a ; 23b) perméable au gaz, qui est disposé à l'intérieur de la chambre de réaction (5 ; 6b) entre ladite au moins une conduite d'admission du gaz (12 ; 12b) et la paroi intérieure (4 ; 4b) du récipient (3 ; 3b) du réacteur et comporte au moins un matériau qui, agissant comme catalyseur, accélère la décomposition du gaz (2).

2. Réacteur selon la revendication 1, **caractérisé en ce que** ledit au moins un élément catalyseur (23a) est réalisé de telle sorte qu'il entoure totalement ladite au moins une conduite d'admission du gaz (12).

3. Réacteur selon la revendication 2, **caractérisé en ce que** ladite au moins une conduite d'admission de gaz auxiliaire (13) pour l'admission d'un gaz inerte (14) est disposée entre la paroi intérieure (4) et ledit au moins un élément catalyseur (23a).

4. Réacteur selon l'une quelconque des revendications 1 à 3, **caractérisé en ce que** ledit au moins un élément catalyseur (23 ; 23a ; 23b) peut être chauffé par voie électrique.

5. Réacteur selon la revendication 4, **caractérisé en ce que** la température T_{G} de l'élément catalyseur (23 ; 23a ; 23b) est supérieure à la température T_{I} sur la paroi intérieure (4 ; 4b).

6. Réacteur selon l'une quelconque des revendications précédentes, **caractérisé en ce que** ledit au moins un élément catalyseur (23 ; 23a ; 23b) est réalisé dans au moins un matériau qui est résistant à chaud jusqu'à une température de 1 200 °C au moins, en particulier 1 600 °C au moins et en particulier 2 000 °C au moins.

7. Réacteur selon l'une quelconque des revendications précédentes, **caractérisé en ce que** ledit au moins un élément catalyseur (23 ; 23a ; 23b) est réalisé dans un métal, en particulier au moins un des éléments molybdène, tantale, niobium et tungstène.

8. Réacteur selon l'une quelconque des revendications précédentes , **caractérisé en ce que** ledit au moins un élément catalyseur (23) s'étend au moins sur toute sa surface le long d'une partie (7) du récipient (3) du réacteur, qui est chauffé par ledit au moins un dispositif de chauffage (17).

9. Réacteur selon l'une quelconque des revendications 1 à 8, **caractérisé en ce qu'**au moins un élément de refroidissement (31) est disposé entre ledit au moins un élément catalyseur (23b) et le dispositif de chauffage (17b).

10. Réacteur selon l'une quelconque des revendications 1 à 9, **caractérisé en ce que** ledit au moins un élément catalyseur (23b), le long d'une direction d'afflux (16) du gaz (2) contenant du silicium, est situé à une distance du dispositif de chauffage (17b) dans une plage de 1 mm à 500 mm, en particulier de 5 mm à 200 mm et en particulier de 10 mm à 100 mm.

11. Réacteur selon l'une quelconque des revendications 1 à 10, **caractérisé en ce que** le réacteur (1b) est réalisé de telle sorte que le gaz (2) contenant du silicium possède dans la zone de la chambre de réaction (6 ; 6b) une température moyenne de moins de 800 °C, en particulier de moins de 650 °C et en particulier de moins de 500 °C.

12. Réacteur selon l'une quelconque des revendications précédentes, **caractérisé en ce qu'**une autre conduite d'admission du gaz (34) destinée à acheminer un gaz contenant du silicium est disposée entre ledit au moins un élément catalyseur (23b) et ledit au moins un dispositif de chauffage (17b).

13. Procédé pour la production de silicium qui, en tant que matériau de départ, convient à la fabrication de blocs de silicium polycristallin ou de cristaux de silicium pour la technologie photovoltaïque, comportant les étapes suivantes :
a. préparation d'un réacteur (1 ; 1a ; 1b) pour la décomposition d'un gaz (2) contenant du silicium, comportant
i. un récipient (3 ; 3b) du réacteur avec une chambre de réaction (6 ; 6b), entourée par une paroi intérieure (4 ; 4b) et destinée à recevoir un gaz (2) contenant du silicium, au moins une conduite d'admission du gaz (12 ; 12b) pour acheminer le gaz (2) dans la chambre de réaction (6 ; 6b), et une conduite d'admission de gaz auxiliaire (13) de forme annulaire, entourant la conduite d'admission du gaz (12 ; 12b) et destinée à acheminer un gaz inerte (14),
ii. au moins un dispositif de chauffage (17 ; 17b), disposé à l'extérieur de la chambre de réaction (6 ; 6b) et destiné à chauffer la chambre de réaction (6 ; 6b), et
iii. au moins un élément catalyseur (23 ; 23a ; 23b) perméable au gaz, qui est disposé à l'intérieur de la chambre de réaction (6 ; 6b) entre ladite au moins une conduite d'admission du gaz (12 ; 12b) et la paroi intérieure (4 ; 4b) du récipient (3 ; 3b) du réacteur et comporte au moins un matériau qui, agissant comme catalyseur, accélère la décomposition du gaz (2),
b. acheminement du gaz (2) contenant du silicium dans la chambre de réaction (6 ; 6b), de telle sorte qu'au moins une partie du gaz (2) passe à travers ledit au moins un élément catalyseur (23 ; 23a ; 23b),
c. décomposition thermique du gaz (2) acheminé, moyennant la formation du silicium, et
d. extraction du silicium formé hors du gaz (2).

14. Procédé pour la production de silicium selon la revendication 13, **caractérisé en ce que** ledit au moins un élément catalyseur (23 ; 23a ; 23b) est chauffé au moins jusqu'à une température (T_{G}) qui, en comparaison avec une température (T_{I}) de la paroi intérieure (4 ; 4b), est supérieure à celle-ci.

15. Procédé pour la production de silicium selon la revendication 13 ou 14, **caractérisé en ce que** le gaz (2) contenant du silicium, après le passage à travers ledit au moins un élément catalyseur (23b) et avant la décomposition thermique, est refroidi au moyen d'au moins un élément de refroidissement (31).

16. Procédé pour la production de silicium selon l'une quelconque des revendications 13 à 15, **caractérisé en ce que** le gaz (2) contenant du silicium, au moment du passage à travers ledit au moins un élément catalyseur (23b), possède une température moyenne de moins de 800 °C, en particulier de moins de 650 °C et en particulier de moins de 500 °C.

17. Procédé selon la revendication 13, **caractérisé en ce qu'**un gaz (2) contenant du silicium est à nouveau acheminé dans le récipient (3b) du réacteur entre ledit au moins un élément catalyseur (23b) et ledit au moins un dispositif de chauffage (17b).
